# EUROPEAN PATENT SPECIFICATION

(11) **EP 0 647 387 B1**
(45) Date of publication and mention of the grant of the patent: **22.05.1996**
(21) Application number: 93913396.3
(22) Date of filing: 18.06.1993
(51) Int. Cl.: H05B 39/04, F21V 29/00

(54) **DIMMER ARRAYS**
DIMMERANORDNUNGEN
GROUPEMENTS DE VARIATEURS DE LUMIERE

(30) Priority: 22.06.1992 GB 9213199
(43) Date of publication of application: 12.04.1995
(73) Proprietor: ELECTROSONIC LIMITED, Dartford, Kent DA2 7SY (GB)
(72) Inventor: MILNER, Merlin Ground Floor Flat, London E5 0LE (GB); FORREST, Trevor 38 Edison Grove, London SE18 2DN (GB)
(74) Representative: Jennings, Nigel Robin
(86) International application number: GB9301295
(87) International publication number: WO9400964

(56) References cited:
- GB-A- 1 597 941
- US-A- 4 539 625
- PATENT ABSTRACTS OF JAPAN, unexamined applications, P section, vol. 13, no. 511, November 16, 1989, THE PATENT OFFICE JAPANESE GOVERNMENT page 45 P 961, No. 01 - 207 661

## Description

The present invention relates to dimmer arrays, that is to say a plurality of dimmers mounted together in a stack or array and forming a single structural unit. As is known, dimmers are electronic circuits used to control the intensity of lights and incorporate at least one electronic component, such as a thyristor or triac which, by adjustment of a low voltage circuit, controls the power in a high-voltage lighting circuit. The choke or inductance which is normally present also generates heat.

It is increasingly common for large buildings or architectural complexes, such as shopping malls, offices and entertainment complexes to include a very large number of lights controlled by a complex control system including a number of dimmers which are arranged to control different lights and which in turn are controlled by a common control unit which controls the relative intensity of the various lights in accordance with a number of selectable predetermined light intensity programs or a time-dependent light intensity program. Such control systems thus necessitate the provision of a large number of dimmers which are generally arranged together in one or more stacks or arrays. However, the positioning of a large number of heat-generating electronic components, each of which may control up to 20 amps, in close physical proximity poses considerable problems as regards dissipating the substantial amount of heat that is generated.

Conventional dimmer arrays comprise a large number of dimmers supported in a skeletal metallic rack. Each dimmer is contained in an oversized metallic box in which holes are formed to permit the passage of air through it and on one of whose side surfaces heat dissipating fins are provided. Considerable importance is attached by architects and the owners and users of buildings to minimising both the floor area and volume occupied by dimmer arrays but the efficiency of heat dissipation in known dimmer arrays, which relies on diffuse and undirected convection air currents through the metallic boxes and over the heat-dissipating fins, is such that the size of the boxes can not be reduced and nor can the size of the fins which result in the boxes being laterally spaced apart by a considerable distance. Furthermore, while the dimmers in conventional arrays may be rated to control a 20A lighting current, the cooling efficiency is such that, if a significant number of dimmers in the same array is "on" at the same time it must be ensured that the current handled by each of them does not exceeds about 10A in order to avoid the array overheating.

It is therefore the object of the invention to provide a dimmer array in which the dimmers are all satisfactorily cooled but which occupies a reduced floor area and has a higher energy density than known dimmer arrays, that is to say can satisfactorily control a higher power per unit volume of the array than known arrays.

According to the present invention a dimmer array comprises a plurality of dimmers, each of which includes at least one component which, in use, generates heat, e.g. a thyristor and a choke, and a support unit which defines an upwardly extending air duct and removably supports the dimmers one above the other, each dimmer defining an air passage which is inclined by at least 20° to the horizontal and whose lower end communicates with the air duct, the air passage communicating with the atmosphere at one or more positions remote from its lower end.

Thus in the dimmer array in accordance with the invention each dimmer defines an air passage which is inclined to the horizontal by at least 20° and preferably by between 40 to 50° and which communicates at its lower end with an air duct and at some point remote from its lower end, that is to say its upper end and/or one or more sides, with the atmosphere. There is thus a clearly defined pattern of air flow paths through the dimmer array and the flow of air along these flow paths is assisted by the natural convection which occurs when heat is generated. Air thus flows up the air duct and into the passages defined by the dimmers and its flow through the dimmers is promoted by the convection which occurs due to the fact that the dimmers are inclined to the horizontal.

It is preferred that each dimmer comprises a flat generally rectangular enclosure which contains the heat-generating component. This is, however, not essential and each dimmer may only have a single planar panel, e.g. a circuit board carrying the various electronic components. In this case the air passages will be defined by the planar panels of adjacent dimmers.

If the dimmers are of relatively low power and thus generate a relatively small amount of heat the lower end of the air duct may simply communicate with the atmosphere and the resulting convection currents through the air duct and passages are sufficient to maintain the dimmers cool. If, however, the dimmers are of higher power the support unit may further support a fan whose inlet communicates with the atmosphere and whose outlet communicates with the air duct and which, in use, blows air into the air duct and then through the air passages. In this case it is found that the cooling efficiency is so much higher than in known dimmer arrays that the energy density of the dimmer array is very considerably increased and each dimmer may handle 20A without overheating occurring.

In the preferred embodiment the support unit includes two side walls, each of which carries a plurality of projections which support the dimmers one above the other, an apertured partition which engages the rear surfaces of the dimmers and through which, in use, air passes from the air duct into the dimmers and a rear wall, the air duct being defined by the side and rear walls and the partition. The dimmers are thus slidably supported on the projections and are simply inserted through the open front of the support unit and slid on the associated projections until their rear surface engages the partition. Whilst the rear wall of the support unit may constitute a part of that unit, it will be appreciated that it is equally possible for the support unit itself to have no rear wall and for the rear wall to be constituted by the wall of a building or the like to which the support unit is connected.

If a fan is present there is a tendency for a greater proportion of the air flowing into the air duct to flow out through those dimmers which are closest to the fan but in the preferred embodiment of the invention this can be counteracted by the provision of a plurality of baffle plates on the partition which project into the air duct at positions arranged between respective pairs of adjacent dimmers, each baffle plate extending further into the air duct than the baffle plate beneath it. The baffle plates thus create back-pressures adjacent the inlets to the dimmers and are appropriately sized in relation to one another that the air flow through each dimmer is substantially the same.

As described above, the support unit effectively defines a plurality of spaces for the accommodation of dimmers and each of these spaces may be occupied by a respective dimmer. However, it is possible that one or more of the spaces are not so occupied and in this event there would be a tendency for an increased volume of air to flow through those spaces due to the fact that an empty space will present a lesser flow resistance than a dimmer. This potential problem may be counteracted by the provision of at least one spring-loaded restrictor flap associated with each dimmer which is normally pressed by the associated dimmer against an associated side wall but which is moved by the spring force when the associated dimmer is removed from the support unit to a position in which it obscures a proportion of the area over which the air duct communicates with the space vacated by the dimmer. The restrictor flaps will in practice be so dimensioned that the air resistance presented by each space within the support unit is substantially the same regardless of whether or not it is occupied by a dimmer.

As is conventional, each dimmer will include low voltage circuitry by which the thyristor or the like is controlled. This circuitry must be connected to a controller and in the preferred embodiment this is effected by means of a plurality of fixed plug connectors connected to the support unit which cooperate with respective plug connectors on the dimmers which are connected to the low voltage components of the dimmers. Since the dimmers are inclined to the horizontal, their plug connectors will also be similarly inclined and the plug connectors carried by the support unit should therefore be inclined also so that cooperating pairs of plug connectors automatically effect the desired connections when the dimmers are slid into position in the support unit. The plug units carried by the support unit are in practice likely to be connected to the same controller and should therefore all be connected together and this is conveniently effected by means of a flexible printed circuit board which is readily capable of the deformation necessary to accommodate the inclination of the plug connectors. Whilst the common controller may be remote from the dimmer array, it is preferred that it is accommodated in one of the spaces defined by the support unit and that it is therefore of substantially the same external shape as the dimmers.

Further features and details of the invention will be apparent from the following description of one specific embodiment which is given by way of example with reference to the accompanying drawings, in which:

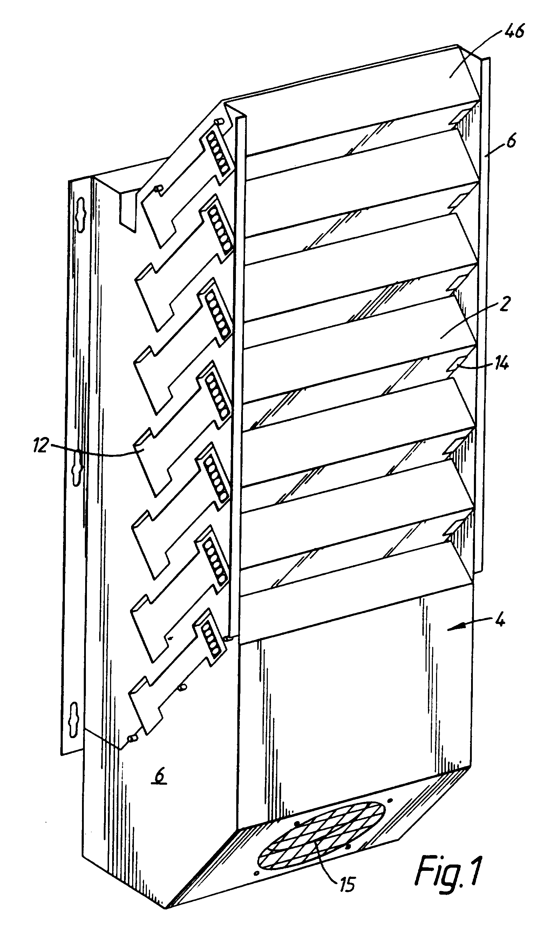

Figure 1 is a perspective view from the front and one side of a dimmer array in accordance with the invention;
Figure 2 is a diagrammatic vertical sectional view of the dimmer array;
Figure 3 is a perspective view from the rear and one side of an individual dimmer;
Figure 4 is a perspective view from the front and the other side of the dimmer of Figure 3; and
Figure 5 is a scrap view of the rear portion of the support unit.

The dimmer array illustrated in the drawings comprises six dimmers 2 slidably supported one above the other in a support unit or stacker 4. The support unit includes two side walls 6, a rear wall 8 and a partition 10 which extends parallel to but spaced from the rear wall 8. Defined between the rear wall 80 and the partition 10 is an air duct 11 whose lower end communicates with the outlet of a fan 13 accommodated within the lower portion of the support unit. The inlet of the fan 13 communicates with the atmosphere through an opening 15 covered by a mesh in the front of the support unit. The majority of the front of the support unit is open. Each side wall 6 has a plurality of vertically spaced holes 12 formed in it of generally H-shape. These holes 12 are formed partially by stamping and partially by bending portions of metal inwardly to form lugs 14. The lugs 14 are so positioned that they define between them a plurality of vertically spaced support surfaces which extend downwardly at 45° and into the support unit from its front surface.

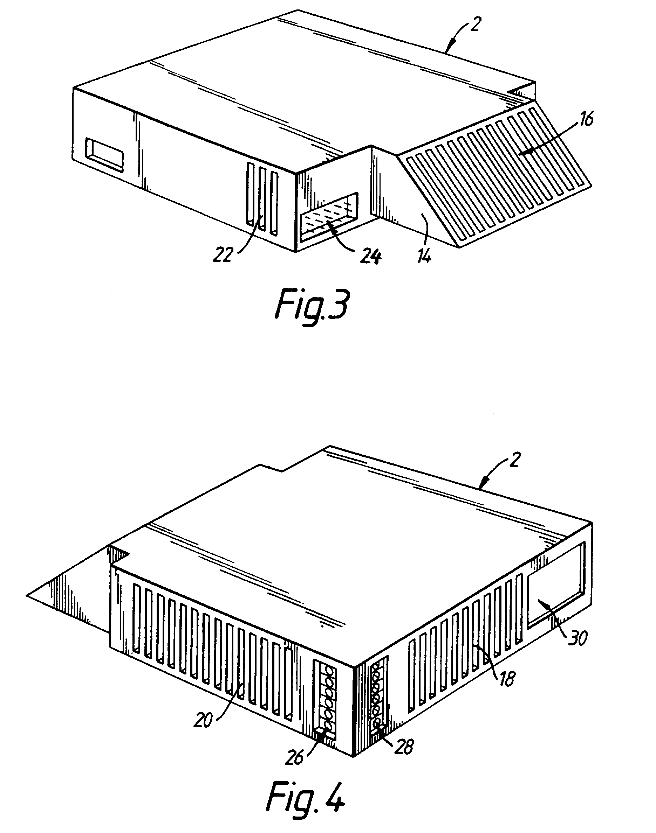

Slidably supported on the lugs 14 are the dimmers 2 whose external construction is best seen in Figures 3 and 4. Each dimmer is of overall generally flat rectangular shape but at the centre of its rear surface there is a protuberance 14 whose rear surface is inclined by 45° to the plane of the dimmer and is constituted by an air inlet grille 16. On the front surface of the dimmer is an air outlet grille 18 and on each side surface there are further outlet grilles 20 and 22. Additionally situated on the rear surface of the dimmer is a recessed plug connector 24 whose contacts are connected to the low voltage components of the dimmer. The internal construction of the dimmer is known per se and forms no part of the present invention but the dimmer does of course include a thyristor or similar electronic component which is mounted on a heat sink and which controls an associated lighting circuit and is controlled by a low voltage circuit. Each dimmer may include only a single channel, that is to say may be able to control only a single lighting circuit, or it may contain two or even more channels. The power connections for the lighting circuits are constituted by a number of apertures 26 which are situated in one side of the dimmer and cooperate with respective fastening screws 28 on the front of the dimmer. Also positioned on the front of the dimmer is a digital display 30 or the like which indicates the operational status or setting of the dimmer.

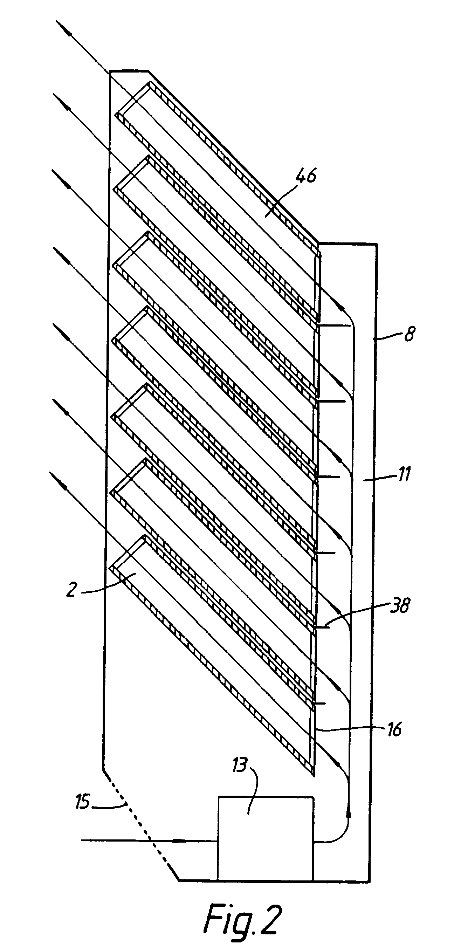

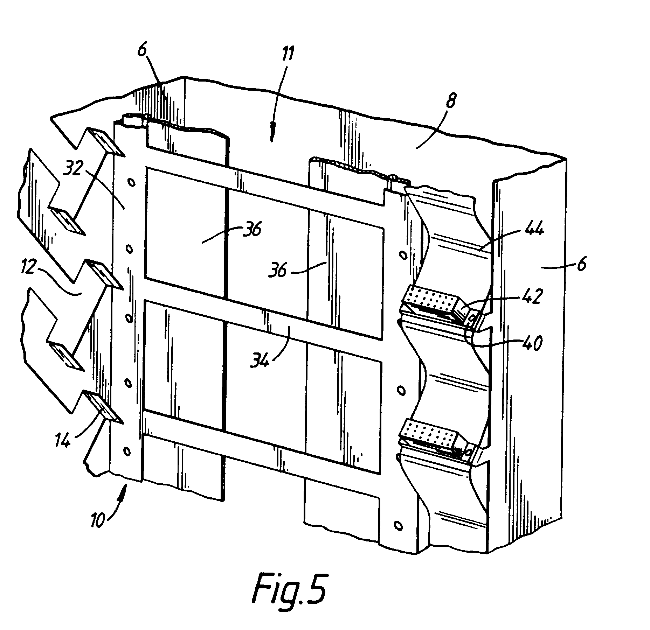

As mentioned above, the support unit 4 includes a partition 10 and this may be best seen in Figure 5. The partition 10 comprises two spaced vertical members 32 connected by spaced parallel horizontal members 34, adjacent pairs of which define spaced rectangular apertures, one of which is associated with each dimmer. Pivotally connected to the rear surface of each upright member 32 is a plurality of restrictor flaps 36, one of which on each upright member 32 is associated with each aperture in the partition 10. A spring (not shown) associated with each flap urges it into the position shown in Figure 5 in which it partially restricts the associated aperture. Connected to the central portion of the rear of each horizontal member 34 of the partition 10 is a baffle 38 (see Figure 2) which extends into the air duct. As may be seen in Figure 2, each baffle 38 extends further into the air duct than the baffle below it.

Connected to one of the side walls 6 is a plurality of brackets 40, each of which is associated with a respective dimmer and is inclined at 45° to the horizontal. Each bracket 40 carries an associated plug connector 42. All the plug connectors 42 are connected by means of a flexible printed circuit board 44 to a central control unit. This control unit may be situated remote from the dimmer array but in the present case the control unit is constituted by a unit 46 which is of the same external shape and dimensions as the dimmers and is positioned in the uppermost space defined by the support unit in a manner similar to the dimmers.

Before the dimmer array is first used, the six dimmers 2 and the control unit 46 are slid into position in the support unit 10 whilst supported on the lugs 14 until their rear surfaces engage the partition 10. As they move towards the partition 10 the plug connectors 26 on the dimmers move into connection with the corresponding connectors 42 on the support unit so that when all the dimmers and control units have been inserted they are automatically connected together via the plug connectors 26, 42 and the printed circuit board 44. Each protuberance 14 extends a short distance into the air duct and as it does so it presses the associated restrictor flaps 36 against the side walls of the air duct. The inlet grille 16 of each dimmer is thus situated a short distance inside the air duct and extends substantially vertically. The high voltage power connectors 26 are accessible through a respective aperture 12 and the lighting circuit power lines are connected to them by appropriately tightening the associated screws 28.

When the dimmer array is to be used, the fan 13 is energised and draws air in through the inlet vent 15 and blows it into the air duct 11 from which it flows through the parallel air passages constituted by the dimmers. The provision of the baffle plates 38 ensures that the air flow rate through each dimmer is substantially the same. The air flowing into each dimmer flows over the associated heat sink and around the or each thyristor and choke and maintains them sufficiently cool and the heated air is then discharged to the atmosphere through the grilles 18, 20 and 22. The heat sink may be of conventional configuration but it is preferred that its surfaces, or at least a major proportion of its surfaces, extend parallel to the plane of the associated dimmer, whereby the air flow through the dimmer flows over these surfaces and satisfactorily removes heat from them.

If it should be desired to remove one of the dimmers whilst the remaining dimmers are in operation, for instance for the purpose of replacing it, once the screws 28 have been released and the power connections removed from the connectors 26 the dimmer can be simply slid out of its space in the support unit and the cooperating plug connectors are automatically disconnected. The springs on the associated flaps 36 cause these flaps to move into the position shown in Figure 5 in which they restrict the communication between the air duct and the space vacated by the dimmer so that the flow resistance presented by this space is substantially the same as that originally presented by the dimmer whereby the air flow through the remaining dimmers remains substantially unaltered.

## Claims

1. A dimmer array comprising a plurality of dimmers (2), each of which includes at least one component which, in use, generates heat, and a support unit (4) which defines an upwardly extending air duct (11) and removably supports the dimmers one above the other, each dimmer defining an air passage which is inclined by at least 20° to the horizontal and whose lower end communicates with the air duct, the air passage communicating with the atmosphere at one or more positions remote from its lower end.

2. An array as claimed in Claim 1 in which the air passage is inclined by 40° to 50° to the horizontal.

3. An array as claimed in Claim 1 or Claim 2 in which the upper end of each air passage communicates with the atmosphere.

4. An array as claimed in any one of Claims 1 to 3 in which each dimmer (2) comprises a flat generally rectangular enclosure which contains the heat-generating component.

5. An array as claimed in any one of the preceding claims in which the support unit (4) further supports a fan (13) whose inlet (15) communicates with the atmosphere and whose outlet communicates with the air duct (11).

6. An array as claimed in any one of the preceding claims in which the support unit includes two side walls (6), each of which carries a plurality of projections (14) which support the dimmers (2) one above the other, an apertured partition (10) which engages the rear surfaces of the dimmers (2) and through which, in use, air passes from the air duct (11) into the dimmers, and a rear wall (8), the air duct being defined by the side and rear walls (6,8) and the partition.

7. An array as claimed in Claim 5 or 6 in which the partition (10) carries a plurality of baffle plates (38) which project into the air duct (11) at positions arranged between respective pairs of adjacent dimmers (2), each baffle plate extending further into the air duct than the baffle plate beneath it.

8. An array as claimed in Claim 5 or 6 including at least one spring-loaded restrictor flap (36) associated with each dimmer (2) which is normally pressed by the associated dimmer against an associated side wall but which is moved by the spring force when the associated dimmer is removed from the support unit (4) to a position in which it obscures a proportion of the area over which the air duct (11) communicates with the space vacated by the dimmer.

9. An array as claimed in any one of Claims 6 to 8 in which the support unit (4) carries a plurality of fixed plug connectors (42) which cooperate with respective plug connectors (24) on the dimmers (2) which are connected to the low voltage components of the dimmers.

10. An array as claimed in Claim 9 in which the plug connectors (42) carried by the support unit (4) are all connected together by a flexible printed circuit board (44).

11. An array as claimed in Claim 9 or Claim 10 in which the support unit (4) further supports a control unit (46) arranged to control all the dimmers (2), the control unit being connected to all the plug connectors (42) carried by the support unit.

## Patentansprüche

1. Dimmeranordnung mit einer Vielzahl von Dimmern (2), von denen jeder zumindest eine Komponente umfaßt, die während der Benutzung Wärme erzeugt und mit einer Halterungseinheit (4), welche eine sich aufwärts erstreckende Luftführung (11) bildet und die die Dimmer einen über dem anderen herausnehmbar aufnimmt, wobei jeder Dimmer einen Luftkanal definiert, der um mindestens 20 Grad bezüglich der Horizontalen geneigt ist und dessen unteres Ende mit der Luftführung in Verbindung steht, wobei der Luftkanal an einer oder mehreren von seinem unteren Ende entfernten Stellen mit der Atmosphäre in Verbindung steht.

2. Anordnung nach Anspruch 1, wobei der Luftkanal um 40 - 50 Grad bezüglich der Horizontalen geneigt ist.

3. Anordnung nach Anspruch 1 oder 2, wobei das obere Ende eines jeden Luftkanales mit der Atomosphäre in Verbindung steht.

4. Anordnung nach einem der Ansprüche 1 bis 3, wobei jeder Dimmer (2) eine flache, im wesentlichen rechtwinklige Einfassung umfaßt, welche die wärmeerzeugende Komponente aufnimmt.

5. Anordnung nach einem der vorhergehenden Ansprüche, wobei die Halterungseinheit (4) darüberhinaus einen Ventilator (13) hält, dessen Einlaß (15) mit der Atmosphäre in Verbindung steht und dessen Auslaß mit der Luftführung (11) in Verbindung steht.

6. Anordnung nach einem der vorhergehenden Ansprüche, wobei die Halterungseinheit zwei Seitenwände (6) einschließt, die jeweils eine Vielzahl von Vorsprüngen (14) tragen, die die Dimmer (2) einen über dem anderen halten, eine durchbrochene Trennwand (10), die im Eingriff mit den hinteren Flächen der Dimmer (2) steht und durch die im Betrieb Luft aus der Luftführung (11) in die Dimmer gelangt, sowie eine Rückwand (8), wobei die Luftführung durch die Seiten und Rückwände (6, 8) sowie die Trennwand definiert wird.

7. Anordnung nach Anspruch 5 oder 6, wobei die Trennwand (10) eine Vielzahl von Ablenkplatten (38) trägt, die in die Luftführung (11) vorstehen und an Positionen zwischen jeweiligen Paaren von aneinandergrenzenden Dim ern (2) angeordnet sind, wobei sich jede Ablenkplatte weiter in die Luftführung erstreckt, als die nebengeordnete.

8. Anordnung nach Anspruch 5 oder 6, einschließlich zumindest einer federgespannten Begrenzungsklappe (36), die jedem Dimmer (2) zugeordnet ist und die normalerweise durch den zugeordneten Dimmer gegen eine entsprechende Seitenwand gepresst wird, die im Falle, daß der zugehörige Dimmer aus der Halteeinheit (4) entfernt ist, durch die Feder aber in eine Position gebracht wird, in der sie einen Teil desjenigen Bereiches verdeckt, durch den die Luftführung (11) mit dem durch den Dimmer freigelassenen Raum in Verbindung steht.

9. Anordnung nach einem der Ansprüche 6 bis 8, wobei die Halteeinheit (4) eine Vielzahl von festen Steckverbindungen (42) trägt, die mit jeweiligen Steckverbindungen (24) der Dimmer (2) zusammenwirken, die mit den Niederspannungskomponenten der Dimmer verbunden sind.

10. Anordnung nach Anspruch 9, wobei die Steckverbindungen (42), die in der Halterungseinheit (4) angeordnet sind, durch eine flexible, bedruckte Schaltkreisplatine (44) alle miteinander verbunden sind.

11. Anordnung nach Anspruch 9 oder 10, wobei die Halterungseinheit (4) darüberhinaus eine Steuereinheit (46) trägt, die zur Steuerung aller Dimmer (2) angeordnet ist, wobei die Steuerungseinheit mit den Steckverbindungen (42) verbunden ist, die in der Halterungseinheit angeordnet sind.

## Revendications

1. Groupement de variateurs de lumière comprenant une pluralité de variateurs (2), dont chacun comprend au moins un composant qui, en utilisation, génère de la chaleur, et une unité de support (4) qui définit une conduite d'air s'étendant vers le haut (11) et supporte de façon amovible les variateurs de lumière l'un au-dessus de l'autre, chaque variateur de lumière définissant un passage d'air qui est incliné d'au moins 20° par rapport à l'horizontale et dont l'extrémité inférieure communique avec la conduite d'air, le passage d'air communiquant avec l'atmosphère à une ou plusieurs positions éloignées de son extrémité inférieure.

2. Groupement selon la revendication 1, dans lequel le passage d'air est incliné de 40° à 50° par rapport à l'horizontale.

3. Groupement selon la revendication 1 ou la revendication 2, dans lequel l'extrémité supérieure de chaque passage d'air communique avec l'atmosphère.

4. Groupement selon l'une quelconque des revendications 1 à 3, dans lequel chaque variateur de lumière (2) comprend une enceinte plate, généralement rectangulaire, qui contient le composant générateur de chaleur.

5. Groupement selon l'une quelconque des revendications précédentes, dans lequel l'unité de support (4) supporte en outre un ventilateur (13) dont l'entrée (15) communique avec l'atmosphère et dont la sortie communique avec la conduite d'air (11).

6. Groupement selon l'une quelconque des revendications précédentes, dans lequel l'unité de support comporte deux parois latérales (6) , dont chacune porte une pluralité de saillies (14) qui supportent les variateurs de lumière (2), l'un au-dessus de l'autre, une séparation comportant des ouvertures (10) qui se met en prise avec les faces arrière des variateurs de lumière (2) et à travers laquelle, en utilisation, l'air provenant de la conduite d'air (11) passe dans les variateurs de lumière, et une paroi arrière (8), la conduite d'air étant définie par les parois latérales et arrière (6, 8) et la séparation.

7. Groupement selon la revendication 5 ou 6, dans lequel la séparation (10) porte une pluralité de déflecteurs (38) qui s'étendent dans la conduite d'air (11) à des positions situées entre les paires respectives de variateurs de lumière (2) adjacents, chaque déflecteur s'étendant plus loin dans la conduite d'air que le déflecteur au-dessous de lui.

8. Groupement selon la revendication 5 ou 6, comprenant au moins un volet restricteur rappelé par ressort (36) associé à chaque variateur de lumière (2) qui est normalement rabattu par le variateur de lumière correspondant contre une paroi latérale correspondante mais qui est déplacé par la force de ressort lorsque le variateur de lumière correspondant est retiré de l'unité de support (4) à une position dans laquelle il bouche une partie de la surface sur laquelle la conduite d'air (11) communique avec l'espace libéré par le variateur de lumière.

9. Groupement selon l'une quelconque des revendications 6 à 8, dans lequel l'unité de support (4) porte une pluralité de contacts à fiche fixes (42) qui coopèrent avec les contacts à fiche (24) respectifs des variateurs de lumière (2) qui sont connectés aux composants à faible tension des variateurs de lumière.

10. Groupement selon la revendication 9, dans lequel les contacts à fiche (42) portés par l'unité de support (4) sont tous connectés ensemble par une carte de circuits imprimés (44).

11. Groupement selon la revendication 9 ou la revendication 10, dans lequel l'unité de support (4) supporte en outre une unité de commande (46) agencée pour commander tous les variateurs de lumière (2), l'unité de commande étant connectée à tous les contacts à fiche (42) portés par l'unité de support.
